# EUROPEAN PATENT SPECIFICATION

(11) **EP 3 988 949 B1**
(45) Date of publication and mention of the grant of the patent: **01.01.2025**
(21) Application number: 20825125.6
(22) Date of filing: 30.03.2020
(51) Int. Cl.: G01R 29/08, G01R 29/26

(54) **NOISE SOURCE IDENTIFICATION METHOD AND INFORMATION PROCESSING SYSTEM**
VERFAHREN ZUR IDENTIFIZIERUNG VON RAUSCHQUELLEN UND INFORMATIONSVERARBEITUNGSSYSTEM
PROCÉDÉ D'IDENTIFICATION DE SOURCE DE BRUIT ET SYSTÈME DE TRAITEMENT D'INFORMATIONS

(30) Priority: 18.06.2019 JP 2019112869
(43) Date of publication of application: 27.04.2022
(73) Proprietor: Hitachi, Ltd., Tokyo 100-8280 (JP)
(72) Inventor: PAOLETTI, Umberto, Tokyo 100-8280 (JP)
(74) Representative: Strehl Schübel-Hopf & Partner
(86) International application number: PCT/JP2020/014443
(87) International publication number: WO 2020/255527

(56) References cited:
- EP-A1- 3 455 639
- CN-A- 108 469 560
- JP-A- 2006 084 413
- JP-A- 2007 033 197
- JP-A- 2018 532 983
- JP-A- 2019 028 907
- US-A- 5 949 380
- US-A1- 2013 113 659
- US-A1- 2015 276 840
- GANG FENG ET AL: "Time synchronized near-field and far-field for EMI source identification", ELECTROMAGNETIC COMPATIBILITY, 2008. EMC 2008. IEEE INTERNATIONAL SYMPOSIUM ON, IEEE, PISCATAWAY, NJ, USA, 18 August 2008 (2008-08-18), pages 1 - 5, XP031349566, ISBN: 978-1-4244-1699-8

## Description

### Technical Field

The present invention relates to a noise source identification method and an information processing system.

### Background Art

An electromagnetic noise (EM noise) such as electromagnetic radiation noise and conduction noise emitted from an electronic circuit or the like is required to be suppressed within a range of a predetermined regulation value. When the electromagnetic noise exceeds the range of regulation value, such electromagnetic noise may affect an operation of another surrounding circuit. Therefore, there is a demand for a technique for identifying a noise source that generates an electromagnetic noise exceeding a predetermined regulation value.

In the related art, as a measurement method for identifying a noise source, a method for obtaining a frequency spectrum by frequency domain measurement or a method for obtaining a frequency spectrum by performing time domain measurement and performing short-time Fourier transform (ST-FFT) is known. It is easy to identify a high-frequency noise source (for example, noise from a clock signal circuit or a communication circuit, or the like) from a frequency spectrum.

However, an inverter circuit and a high-output circuit that performs high-speed switching at a low modulation frequency (for example, kHz band) are noise sources capable of generating a wide-band electromagnetic noise. When the noise source of the wide-band electromagnetic noise is identified, a long time is required in the measurement method for identifying the noise source in the related art.

### Citation List

### Patent Literature

PTL 1: JP-A-2014-222215 US 2013/113659 A1 discloses a noise detection apparatus with the features in the preamble of present claim 1. Another conventional noise detecting system is described in EP3455639A1 (WO 2017/195379 A1).

### Summary of Invention

### Technical Problem

From a viewpoint of improving electromagnetic compatibility (EMC), a technique for accurately identifying not only a high-frequency noise source but also a noise source capable of generating a wide-band electromagnetic noise is required. The invention has been made in view of the above problem, and an object of the invention is to provide a noise source identification method and an information processing system capable of easily identifying a noise source that generates a wide-band electromagnetic noise even when the noise source is present.

### Solution to Problem

To solve the above problem, an information processing system according to the invention includes the features defined in claim 1.

In addition, a noise source identification method according to the invention includes the features defined in claim 2.

### Advantageous Effect

According to the invention, it is possible to provide the noise source identification method and the information processing system capable of easily identifying the noise source that generates the wide-band electromagnetic noise even when the noise source is present. Problems, configurations, and effects other than those described above are clear from the following description of embodiments.

### Brief Description of Drawings

[FIG. 1] FIG. 1 is a block diagram illustrating an example of a configuration of a noise source identification device 1 according to a first example useful to understand the invention.
[FIG. 2] FIG. 2 is a flowchart illustrating an execution procedure of a noise source identification method according to the first example.
[FIG 3] FIG. 3 illustrates an example of modulation frequency data (graph) generated in a suspected noise source device and the method according to the first example.
[FIG 4] FIG. 4 illustrates an example of modulation frequency data (graph) generated in the suspected noise source device and the method according to the first example.
[FIG. 5] FIG. 5 is a block diagram illustrating an example of a configuration of a noise source identification device 1A according to a second example useful to understand the invention.
[FIG. 6] FIG. 6 is a flowchart illustrating a procedure of a noise source identification method according to the second example.
[FIG. 7] FIG. 7 is a flowchart illustrating an execution procedure of a noise source identification method according to a third example useful to understand the invention.
[FIG. 8] FIG. 8 is a flowchart illustrating an execution procedure of a noise source identification method according to an embodiment.
[FIG 9] FIG. 9 is a schematic diagram illustrating modulation frequency data for different time frames obtained for each of suspected noise source devices S1 to Sn according to the embodiment.
[FIG. 10] FIG. 10 is a graph illustrating the noise source identification method according to the embodiment.
[FIG. 11] FIG. 11 is a flowchart illustrating an execution procedure of a noise source identification method according to a modification of the embodiment.

### Description of Examples and an Embodiment

Hereinafter, examples and an embodiment of the invention will be described with reference to drawings. The examples are not covered by the scope of the claims but nevertheless useful to understand the invention. The embodiment is an example for describing the invention, and omission and simplification are appropriately made for clarification of the description. The invention can be implemented in various other forms. The number of constituent elements may be singular or plural, unless otherwise specified.

In order to facilitate understanding of the invention, a position, a size, a shape, a range, and the like of each constituent element shown in the drawings may not represent an actual position, size, shape, range, and the like. Therefore, the invention is not necessarily limited to the position, size, shape, range, or the like disclosed in the drawings. Examples of various types of information may be described by expressions such as "table", "list", "queue", "data", and "graph", but the various types of information may be expressed by a data structure other than these expressions. For example, the various types of information such as "XX table", "XX list", and "XX queue" may be "XX information". When identification information is described, expressions such as "identification information", "identifier", "name", "ID", and "number" are used, but these expressions may be replaced with each other. When there are a plurality of constituent elements having the same or similar functions, different subscripts may be attached to the same reference numeral. In addition, when it is not necessary to distinguish the plurality of constituent elements from each other, a description will be given by omitting the subscript.

In the embodiment, a processing performed by executing a program may be described. Here, a computer executes the program by a processor (for example, a CPU or a GPU), and performs the processing defined by the program using a storage resource (for example, a memory), an interface device (for example, a communication port), or the like. Therefore, a subject of the processing performed by executing the program may be the processor. Similarly, the subject of the processing performed by executing the program may be a controller, a device, a system, a computer, or a node including the processor. The subject of the processing performed by executing the program may be a calculation unit, and may include a dedicated circuit that performs a specific processing. Here, the dedicated circuit is, for example, a field programmable gate array (FPGA), an application specific integrated circuit (ASIC), a complex programmable logic device (CPLD), and the like.

The program may be installed on the computer from a program source. The program source may be, for example, a program distribution server or a computer-readable storage medium. When the program source is the program distribution server, the program distribution server may include the processor and the storage resource that stores a program to be distributed, and the processor of the program distribution server may distribute the program to be distributed to another computer. In addition, in the embodiment, two or more programs may be implemented as one program, or one program may be implemented as two or more programs.

### [First Example]

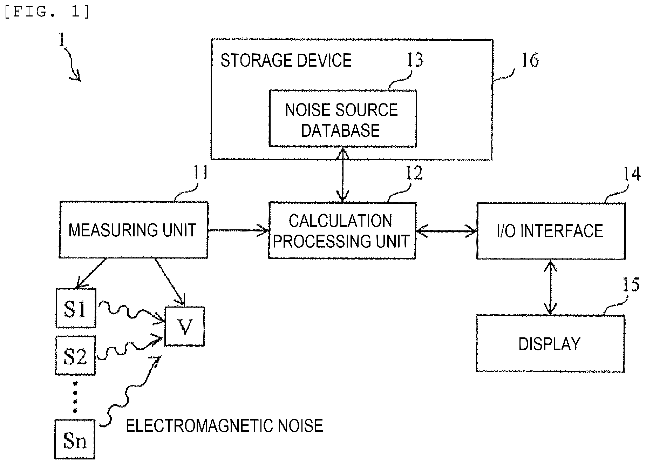

First, a noise source identification device (information processing system) and a noise source identification method according to a first example not covered by the present independent claims will be described with reference to FIGS. 1 to 4. FIG. 1 is a block diagram illustrating an example of a configuration of a noise source identification device 1 according to the first example. As illustrated in FIG. 1, as an example, the noise source identification device 1 of the first example includes a measuring unit 11, a calculation processing unit 12, a storage device 16 that stores a noise source database 13, an I/O interface 14, and a display 15.

As schematically shown in the lower left of FIG. 1, in an environment in which there are a plurality of devices S1 to Sn suspected to be noise sources that generate an electromagnetic noise (hereinafter referred to as "suspected noise source devices") and a device V that receives a noise due to radiation or conduction of such electromagnetic noise (hereinafter referred to as "target device"), this noise source identification device 1 identifies, from among the suspected noise source devices S1 to Sn, a device that applies an electromagnetic noise EMs equal to or greater than a predetermined reference to the target device V.

Here, the electromagnetic noise (EM noise) is, for example, an electromagnetic radiation noise or a conduction noise emitted from an electronic circuit or the like. In addition, an example of the suspected noise source device is a device including, for example, an electronic circuit, and may be simply referred to as a noise source device.

Although not illustrated, the measuring unit 11 includes, for example, a well-known antenna, an amplifier, an A/D converter, and the like, and is configured to measure an electromagnetic noise. A target to be measured of the measuring unit 11 includes the suspected noise source devices S1 to Sn and the target device V. The measuring unit 11 that measures each of the suspected noise source devices S1 to Sn and the target device V may be separate devices or may be the same device.

The calculation processing unit 12 is configured to generate data indicating a time change of the electromagnetic noise according to a measurement result of the measuring unit 11, and generate frequency spectrum data and modulation frequency data of the electromagnetic noise. Specifically, the calculation processing unit 12 can be configured by, for example, a general-purpose computer, and generates the time change data, the frequency spectrum data, the modulation frequency data of the electromagnetic noise, and the like by performing a predetermined calculation processing on measurement data as digital data input from the measuring unit 11. The frequency spectrum data of the electromagnetic noise can be generated by applying a well-known short-time Fourier transform (ST-FFT) to the time change data of the electromagnetic noise, for example.

In addition, as will be described later, the calculation processing unit 12 has a function of generating a graph based on the modulation frequency data of the plurality of suspected noise source devices S1 to Sn stored in the noise source database 13 and the modulation frequency data of the electromagnetic noise received by the target device V measured by the measuring unit 11. This graph is displayed on the display 15 and presented to a user. The user compares this graph and identifies a device (for example, S2), which is a noise source of electromagnetic noise equal to or greater than a predetermined reference value, from among the plurality of suspected noise source devices S1 to Sn according to a result of comparison.

The storage device 16 includes a storage device that stores the noise source database 13. The noise source database 13 is a database that stores frequency spectrum data of electromagnetic noise measured in the vicinity of the suspected noise source devices S1 to Sn and modulation frequency data of electromagnetic noise from the suspected noise source devices S1 to Sn for each suspected noise source device. The frequency spectrum data and the modulation frequency data of the suspected noise source devices S1 to Sn can be generated based on the measurement result in the measuring unit 11, but can also be generated by computer simulation for the suspected noise source devices S1 to Sn instead of or in addition to the actual measurement in the measuring unit 11 and stored in the storage device 16 of the noise source database. In the computer simulation, for example, specification data related to a frequency, such as specifications of the suspected noise source devices S1 to Sn, may be used.

The I/O interface 14 is an interface for outputting data obtained by the calculation processing unit 12 to the display 15 and another external device and for receiving data from the external device. The display 15 is configured to display, for example, modulation frequency data of an electromagnetic noise stored in the noise source database 13 and frequency spectrum data measured by the measuring unit 11. The external device may be, for example, an input device (for example, a keyboard, a mouse, and the like) for a user to input a command (instruction), an external storage device, or a management device connected via a network.

A part or all of the noise source identification device 1 can be configured as an information processing system. The information processing system includes, for example, a measuring unit, a calculation unit, and an output unit. The measuring unit measures an electromagnetic noise received by the target device. The calculation unit calculates, from measurement data of the electromagnetic noise, modulation frequency data in which a frequency of the electromagnetic noise, a modulation frequency of the electromagnetic noise, and an intensity of the electromagnetic noise are associated with each other. The output unit outputs the calculated modulation frequency data.

In addition, the information processing system may further include, for example, a storage unit. The storage unit stores modulation frequency data in which a frequency of an electromagnetic noise generated by one or more devices different from the target device, a modulation frequency of the electromagnetic noise, and an intensity of the electromagnetic noise are associated with each other. Then, the output unit outputs the modulation frequency data calculated for the electromagnetic noise received by the target device and the modulation frequency data calculated for the electromagnetic noise generated by the one or more devices different from the target device.

In addition, the measuring unit may measure the electromagnetic noise generated by the one or more devices different from the target device. Then, the calculation unit may calculate the modulation frequency data from the measurement data of the electromagnetic noise and store the modulation frequency data in the storage unit.

In addition, the storage unit may store information on characteristics of the one or more devices different from the target device. The calculation unit may calculate the modulation frequency data of the electromagnetic noise generated by the one or more devices different from the target device from the information on those characteristics and store the modulation frequency data in the storage unit. Here, the information on the characteristics may be, for example, the specification data related to the frequency such as specifications of the suspected noise source devices S1 to Sn, or a device characteristic information database 13A. From the information on those characteristics, the modulation frequency data of the electromagnetic noise generated by the device may be calculated, for example, by the computer simulation.

Here, for example, the measuring unit may be configured by a measuring device that operates as the measuring unit 11, the calculation unit may be configured by a calculation device that operates as the calculation processing unit 12, and the output unit may be configured by an output device such as the calculation processing unit 12 or the I/O interface 14. The calculation device may be configured with a processor such as a central processing unit (CPU) or a graphics processing unit (GPU), or may include a dedicated circuit that performs a specific processing. Here, the dedicated circuit is, for example, FPGA, ASIC, CPLD, and the like. In addition, the storage device 16 is, for example, a memory and constitutes the storage unit.

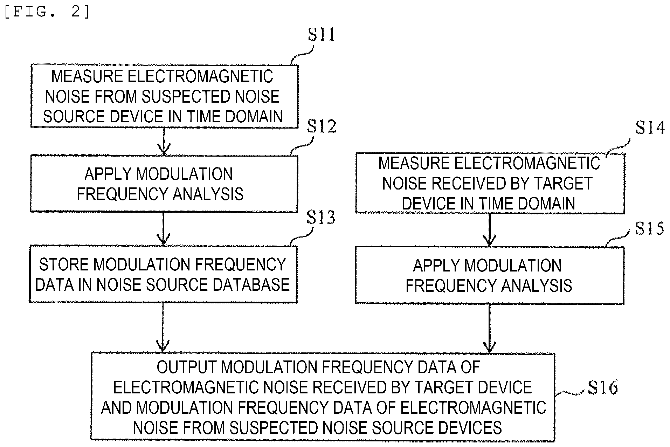

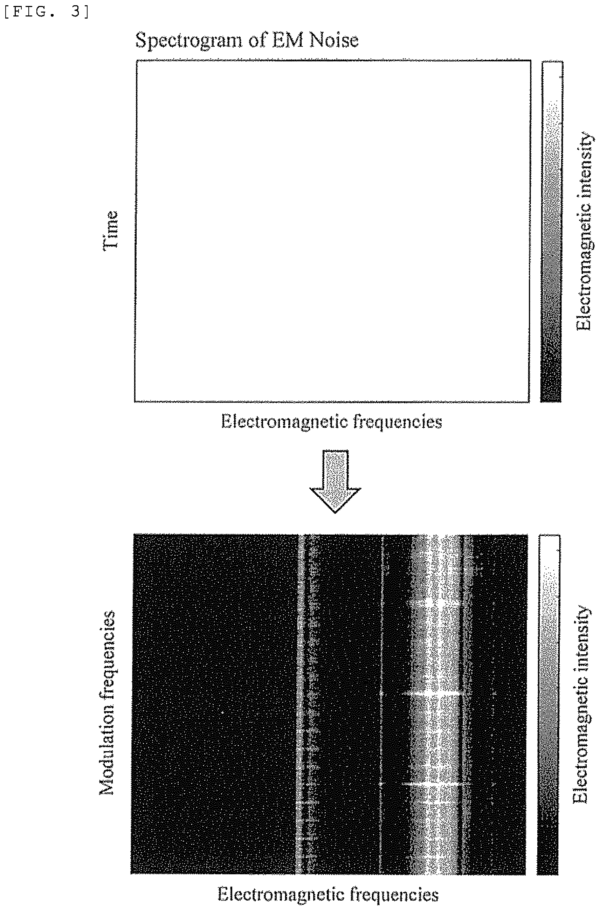

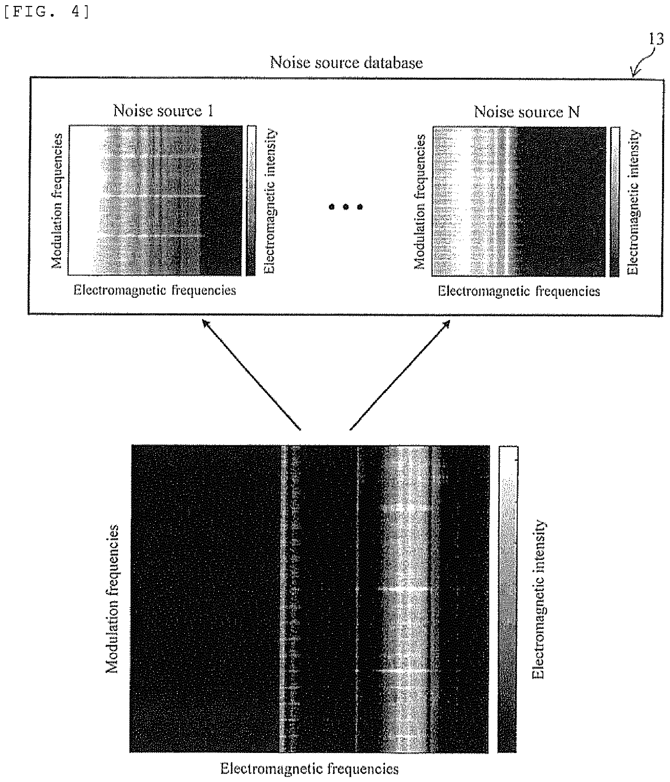

Next, a noise source identification method that can be executed by the noise source identification device 1 of the first example will be described with reference to FIGS. 2 to 4. FIG. 2 is a flowchart illustrating a procedure of this method, and FIGS. 3 and 4 illustrate an example of modulation frequency data (graph) generated by this method.

As shown in FIG. 2, this method is roughly divided into a procedure of generating the noise source database 13 (steps S11 to S13), a procedure of measuring an electromagnetic noise in the target device V (steps S14 to S15), and a specific procedure of a noise source (step S16).

In the step S11, the measuring unit 11 measures an electromagnetic noise from the suspected noise source devices S1 to Sn in a time domain. For example, the measuring unit 11 is arranged in the vicinity of any of the suspected noise source devices S1 to Sn, and measures the electromagnetic noise at that position in the time domain. The electromagnetic noise from the suspected noise source devices S1 to Sn is an electromagnetic noise emitted or conducted from the suspected noise source devices S1 to Sn, and may include, for example, an electromagnetic noise generated by the suspected noise source devices S1 to Sn. In addition, the electromagnetic noise from the suspected noise source devices S1 to Sn may be, for example, an electromagnetic noise measured in the vicinity of the suspected noise source devices or inside the suspected noise source devices S1 to Sn, or may be an electromagnetic noise at positions of the suspected noise source devices S1 to Sn.

In step S12, the calculation processing unit 12 applies modulation frequency analysis to a measuring signal (digital value) of the electromagnetic noise in the time domain and calculates modulation frequency data of the electromagnetic noise from the suspected noise source devices S1 to Sn. Here, the modulation frequency data of the electromagnetic noise is information in which a frequency of the electromagnetic noise, a modulation frequency of the electromagnetic noise, and an intensity of the electromagnetic noise are associated with each other.

In the step S13, the calculation processing unit 12 stores the modulation frequency data of the electromagnetic noise from the suspected noise source device in the noise source database 13. The calculation processing unit 12 generates or updates the noise source database 13. The information processing system executes steps S11 to S13 for the suspected noise source devices S1 to Sn, thereby acquiring the modulation frequency data for each suspected noise source device and storing the modulation frequency data in the noise source database 13.

As shown in an upper figure of FIG. 3 as an example, in a spectrogram of an electromagnetic noise in a time domain, for example, in a graph in which a vertical axis represents time and a horizontal axis represents a frequency of an electromagnetic noise, an intensity of an electromagnetic noise (electromagnetic intensity) can be expressed by brightness or color of the graph. By applying the modulation frequency analysis to the electromagnetic noise data in this time domain, a graph of the modulation frequency data of the electromagnetic noise can be obtained.

In the graph of the modulation frequency data, for example, in a graph in which a vertical axis represents a modulation frequency and a horizontal axis represents a frequency of an electromagnetic noise (electromagnetic frequency), an intensity of an electromagnetic noise (electromagnetic intensity) can be expressed by brightness or color. The graph of the modulation frequency data acquired here is modulation frequency data in which the frequency of the electromagnetic noise of the suspected noise source device, the modulation frequency of the electromagnetic noise of the suspected noise source device, and the intensity of the electromagnetic noise of the suspected noise source device are associated with each other.

The graph of the modulation frequency data illustrated as an example in a lower diagram of FIG. 3 is characterized in that there are periodically high brightness portions in a vertical direction in a frequency region where an electromagnetic noise is present. It is estimated that this corresponds to a fundamental frequency of the electromagnetic noise output by the suspected noise source device and a harmonic thereof. As will be described later, according to such a characteristic, it is possible to identify a suspected noise source device that emits or conducts an electromagnetic noise equal to or higher than a predetermined regulation value to the target device V.

Returning to FIG. 2, the steps S14 to S15 will be described. In the step S14, the measuring unit 11 measures an electromagnetic noise received by the target device V in the time domain. For example, the measuring unit 11 is arranged in the vicinity of the target device V, and measures an electromagnetic noise at a position of the target device V in the time domain. The electromagnetic noise received by the target device V may be, for example, an electromagnetic noise measured in the vicinity of the target device V or the electromagnetic noise at the position of the target device V.

In the step S15, the calculation processing unit 12 applies the modulation frequency analysis to the measuring signal (digital value) of the electromagnetic noise in the time domain and calculates the modulation frequency data of the electromagnetic noise received by the target device V. The graph of the modulation frequency data calculated here is modulation frequency data in which the frequency of the electromagnetic noise of the target device V, the modulation frequency of the electromagnetic noise of the target device V, and the intensity of the electromagnetic noise of the target device V are associated with each other. The calculation processing unit 12 may store the modulation frequency data of the electromagnetic noise received by the target device V in the noise source database 13.

In the step S16, the calculation processing unit 12 outputs the modulation frequency data of the electromagnetic noise received by the target device V (a result obtained by the modulation frequency analysis in step S15) and the modulation frequency data of the electromagnetic noise from the suspected noise source devices S1 to Sn stored in the noise source database 13 (a result obtained by the modulation frequency analysis in step 12) to a storage device, the display 15, an external device, and the like included in the information processing system via the I/O interface 14. For example, when the calculation processing unit 12 outputs the modulation frequency data to the display 15, the modulation frequency data of the electromagnetic noise at the position of the target device V and the modulation frequency data of the suspected noise source devices S1 to Sn may be displayed simultaneously or separately. An instruction of a user may be received from the I/O interface 14, and the calculation processing unit 12 may output the modulation frequency data by an output destination or an output method (for example, a display method) specified by the instruction of the user. Accordingly, the user can compare the modulation frequency data of the electromagnetic noise at the position of the target device V with the modulation frequency data of the suspected noise source devices S1 to Sn on a display screen of the display 15 or the like, and can specify a device that is a generation source (noise source) of the electromagnetic noise received by the target device V among the suspected noise source devices. For example, when the target device V receives an electromagnetic noise exceeding a predetermined reference, such as a regulation value of the electromagnetic noise in the target device V, it is possible to specify the device that is the noise source of the electromagnetic noise, and it is possible to perform a noise countermeasure.

As shown in FIG. 4, the calculation processing unit 12 converts the modulation frequency data of the electromagnetic noise at the position of the target device V and the modulation frequency data of the suspected noise source devices S1 to Sn stored in the noise source database 13 into graphs and displays the graphs on the screen of the display 15. The user looks at this screen, compares the graph of the modulation frequency data for the plurality of suspected noise source devices S1 to Sn with the graph of the modulation frequency data for the target device V, and finds a graph having a most approximate characteristic. In this way, a suspected noise source device corresponding to an identified graph is identified as a noise source affecting the target device V. In addition, the user confirms the characteristic in the graph of the modulation frequency data of the electromagnetic noise at the position of the target device V with respect to a part of the electromagnetic noise such as the electromagnetic noise exceeding the predetermined reference among the electromagnetic noise received by the target device V. Then, if characteristics same as or similar to this characteristic can be confirmed in a graph of modulation frequency data of a certain suspected noise source device, the suspected noise source device can be identified as a noise source of a part of the electromagnetic noise.

As described above, according to the noise source identification method of the first example, by acquiring the modulation frequency data of the electromagnetic noise for the suspected noise source devices S1 to Sn, storing the modulation frequency data in the noise source database 13, and comparing the data with the modulation frequency data of the electromagnetic noise received by the target device V, it is possible to identify the noise source that emits the electromagnetic noise equal to or greater than the predetermined reference value.

In the case of the measuring signal of the electromagnetic noise in the time domain, if the electromagnetic noise is in a wide band, amplitude of the noise may be flat over a wide range, and it may be difficult to specify the noise source. However, in the noise source identification device and method of the first example, the modulation frequency analysis can be performed on the electromagnetic noise from the suspected noise source devices S1 to Sn and the electromagnetic noise received by the target device V to acquire and compare the modulation frequency data. Therefore, according to the first example, even if there is a noise source that generates a wide band electromagnetic noise, it is possible to easily identify the noise source.

### [Second Example]

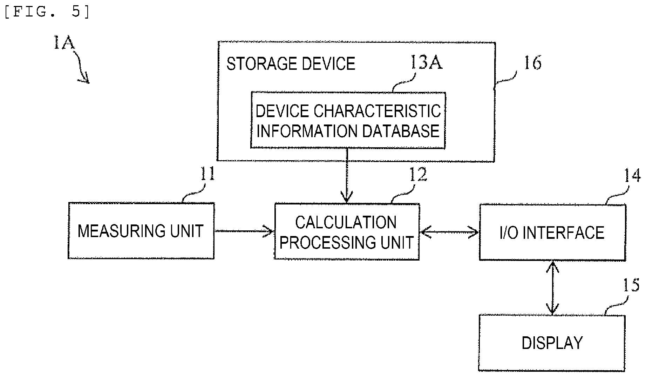

Next, a noise source identification device (information processing system) and a noise source identification method according to a second example not covered by the present independent claims will be described with reference to FIGS. 5 to 6. FIG. 5 is a block diagram illustrating an example of a configuration of a noise source identification device 1A according to the second example. Since the same configurations as those in the first example are denoted by the same reference numerals as those in FIG. 1, a duplicate description will be omitted below. A storage device 16 of this noise source identification device 1A has a device characteristic information database 13A instead of or in addition to the noise source database 13.

The device characteristic information database 13A stores information (characteristic information) on a characteristic of a device, such as product specifications of suspected noise source devices S1 to Sn, for each suspected noise source device. For example, when the suspected noise source device is an inverter circuit, as an example, a rated output, a capacitance, a rated input voltage, a rated output voltage, an output frequency range, a control method, and the like of the device are stored as data. The calculation processing unit 12 compares the data (characteristic information) on this device characteristic with modulation frequency data obtained for the target device V, and identifies a suspected noise source device that outputs an electromagnetic noise exceeding a predetermined regulation value according to this comparison result.

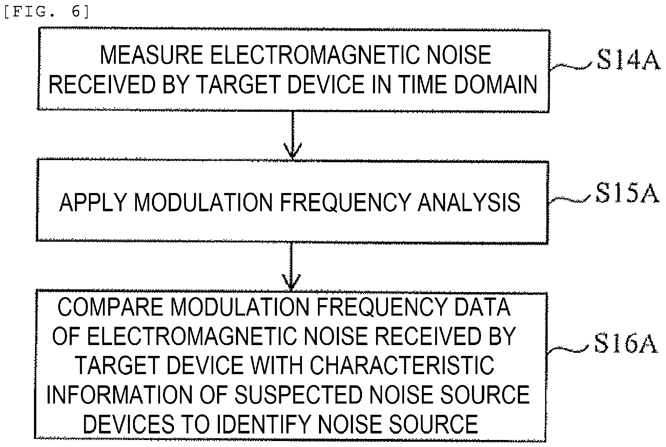

With reference to a flowchart of FIG. 6, the noise source identification method that can be executed by the noise source identification device 1A of the second example will be described. A description will be given on the assumption that that the device characteristic information database 13A has already registered the data on the device characteristics of the suspected noise source devices S1 to Sn.

Steps S14A and S15A of FIG. 6 are the same as the steps S14 and S15 of FIG. 2. In step S16A, modulation frequency data (a result of modulation frequency analysis) of an electromagnetic noise at a position of the target device V obtained in the step S15A is compared with data of device characteristic (characteristic information) stored in the device characteristic information database 13A, and a suspected noise source device estimated to radiate an electromagnetic noise exceeding a regulation value is identified. It is also possible to estimate the modulation frequency data of the electromagnetic noise output from the suspected noise source devices S1 to Sn from the device characteristic data stored in the device characteristic information database 13A, and by comparing with this estimation result, it is possible to identify a suspected noise source device that has the greatest influence on the target device V, as in the first example.

A part or all of the noise source identification device 1A can be configured as the information processing system. The information processing system includes, for example, a measuring unit, a calculation unit, and an output unit. The measuring unit measures an electromagnetic noise received by the target device. The calculation unit calculates, from measurement data of the electromagnetic noise, modulation frequency data in which a frequency of the electromagnetic noise, a modulation frequency of the electromagnetic noise, and an intensity of the electromagnetic noise are associated with each other. The output unit outputs the calculated modulation frequency data.

In addition, the information processing system may further include, for example, a storage unit. The storage unit stores characteristic information on characteristics of one or more devices different from the target device. Then, the output unit outputs the modulation frequency data and the characteristic information.

In addition, the calculation unit compares the characteristic information with the modulation frequency data, and identifies a device that generates at least a part of the electromagnetic noise received by the target device from the one or more devices.

Here, for example, the measuring unit may be configured by a measuring device that operates as the measuring unit 11, the calculation unit may be configured by a calculation device that operates as the calculation processing unit 12, and the output unit may be configured by an output device such as the calculation processing unit 12 or the I/O interface 14. In addition, the storage device 16 is, for example, a memory and constitutes the storage unit. The characteristic information on the characteristic of the one or more devices different from the target device may be, for example, information on characteristic of a device stored in the device characteristic information database 13A for each suspected noise source device.

### [Third Example]

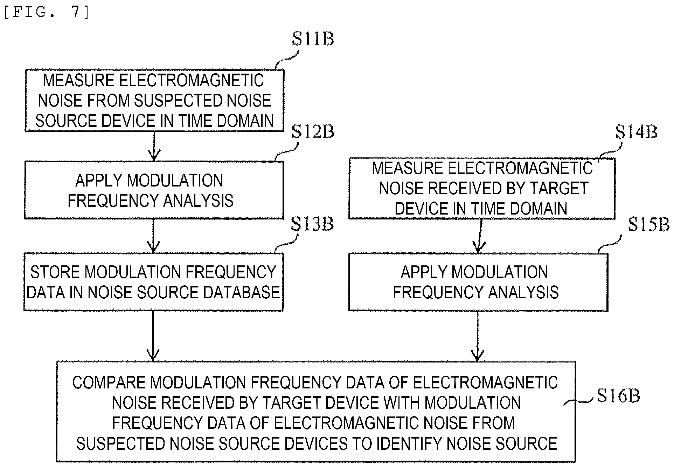

Next, a noise source identification device (information processing system) and a noise source identification method according to a third example not covered by the present independent claims will be described with reference to FIG. 7. Since a configuration of the noise source identification device according to the third example can be the same as the configuration of the first example, a duplicate description will be omitted below.

In the first example, the modulation frequency data of the suspected noise source devices S1 to Sn and the modulation frequency data of the target device V are acquired, and the comparison between both data is visually performed by the user based on the graph of the modulation frequency data displayed on the screen of the display 15. In the third example, the calculation processing unit 12 performs comparison in accordance with a characteristic amount (a matching index) of both data to identify a noise source. Therefore, in the device of the third example, it is not necessary to display the graph of the modulation frequency data on the screen of the display 15 (it is possible to use the display on the display 15 together). As an example, a calculation processing in the calculation processing unit 12 can be a calculation processing using a well-known search algorithm, an expert system, a neural network, and the like.

Next, the noise source identification method that can be executed by the noise source identification device of the third example will be described with reference to a flowchart of FIG. 7. A procedure of generating the noise source database 13 (steps S11B to S13B) and a procedure of measuring an electromagnetic noise in the target device V (steps S14B to S15B) are the same as steps S11 to S13 and S14 to S15 of the first example (FIG. 2).

In step S16B, the calculation processing unit 12 compares modulation frequency data of an electromagnetic noise received by the target device V (a result obtained by the modulation frequency analysis of step S15B) with modulation frequency data of an electromagnetic noise from the suspected noise source devices S1 to Sn stored in the noise source database 13 (a result obtained by the modulation frequency analysis of step 12B) based on an extracted matching index. Then, based on this comparison result, a suspected noise source device that is estimated to generate an electromagnetic noise exceeding the regulation value is identified. Information on the identified suspected noise source device is displayed on the display 15. Thereby, as in the above examples, the suspected noise source device that has the greatest influence on the target device V can be identified.

The calculation processing unit 12 compares a graph of modulation frequency data of an electromagnetic noise from a plurality of suspected noise source devices S1 to Sn with a graph of the modulation frequency data of the electromagnetic noise received by the target device V, and finds a graph having a most approximate characteristic. For example, the calculation processing unit 12 calculates a degree of similarity between images of both graphs, and identifies a graph of modulation frequency data of an electromagnetic noise from a suspected noise source device having a high degree of similarity to the graph of the modulation frequency data of the electromagnetic noise received by the target device V. The calculation processing unit 12 identifies or estimates that the suspected noise source device corresponding to the graph identified in this manner is the noise source affecting the target device V.

In addition, the calculation processing unit 12 identifies the characteristic in the graph of the modulation frequency data of the electromagnetic noise received by the target device V with respect to a part of the electromagnetic noise such as an electromagnetic noise exceeding the predetermined reference among the electromagnetic noise received by the target device V. Then, the calculation processing unit 12 determines whether the characteristic same as or similar to the identified characteristic is in the graph of the modulation frequency data of the electromagnetic noise from the suspected noise source devices S1 to Sn. As a result of the determination, when a graph of modulation frequency data of an electromagnetic noise from a certain suspected noise source device has the characteristic same as or similar to the above identified characteristic, the suspected noise source device can be identified or estimated as the noise source of a part of the electromagnetic noise.

A part or all of the noise source identification device 1 can be configured as the information processing system. The information processing system includes, for example, a measuring unit, a calculation unit, and an output unit. The measuring unit measures an electromagnetic noise received by the target device. The calculation unit calculates, from measurement data of the electromagnetic noise, modulation frequency data in which a frequency of the electromagnetic noise, a modulation frequency of the electromagnetic noise, and an intensity of the electromagnetic noise are associated with each other. The output unit outputs the calculated modulation frequency data.

In addition, the information processing system may further include, for example, a storage unit. The storage unit stores information on one or more devices different from the target device. Then, the calculation unit compares the information on the one or more devices with the modulation frequency data, and identifies a device that generates at least a part of the electromagnetic noise from among the one or more devices. The information on the one or more devices may be information on the electromagnetic noise generated by the one or more devices.

Here, for example, the measuring unit may be configured by a measuring device that operates as the measuring unit 11, the calculation unit may be configured by a calculation device that operates as the calculation processing unit 12, and the output unit may be configured by an output device such as the calculation processing unit 12 or the I/O interface 14. In addition, the storage device 16 is, for example, a memory and constitutes the storage unit. The information on the electromagnetic noise generated by the one or more devices may be, for example, the modulation frequency data of the electromagnetic noise from the suspected noise source devices S1 to Sn stored in the noise source database 13.

### [Embodiment]

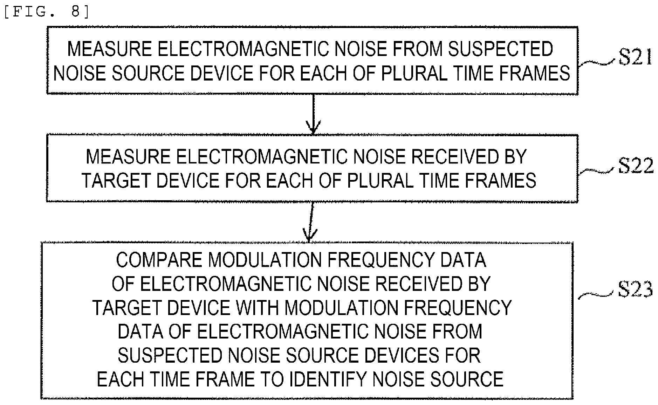

Next, a noise source identification device (information processing system) and a noise source identification method according to an embodiment will be described with reference to FIGS. 8 to 10. Since a configuration of the noise source identification device according to the embodiment can be the same as the configuration of the first example, a duplicate description will be omitted below. However, in the embodiment, the noise source database 13 stores different modulation frequency data for different time frames for each of a plurality of suspected noise source devices S1 to Sn. Then, the calculation processing unit 12 calculates a matching index between the modulation frequency data of the noise source database 13 and the modulation frequency data of the target device V for each of the different time frames, and identifies a noise source.

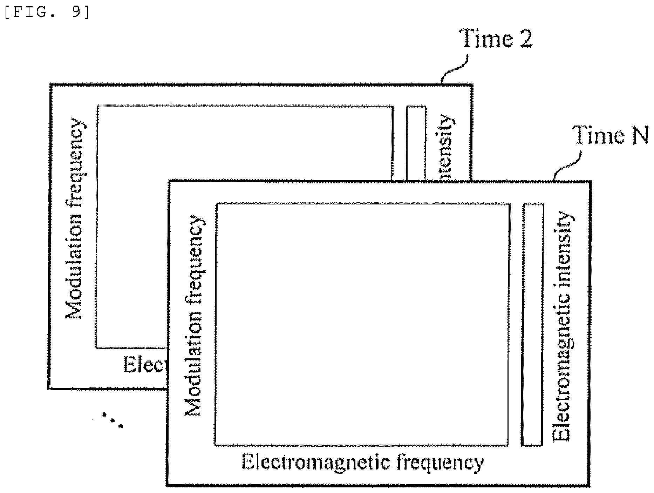

An operation of this noise source identification device will be described with reference to a flowchart of FIG. 8. A procedure of generating the noise source database 13 in step S21 (FIG. 8) is the same as the steps S11 to S13 of the first example. FIG. 9 is a schematic diagram illustrating the modulation frequency data for the different time frames obtained for each of the suspected noise source devices S1 to Sn. The measuring unit 11 measures the electromagnetic noise from each of the suspected noise source devices S1 to Sn separately for each of different time frames Time1, Time2, ..., TimeN. The measurement data of the electromagnetic noise from the suspected noise source devices S1 to Sn is measurement data obtained by measuring the electromagnetic noise from the suspected noise source devices S1 to Sn for each of a plurality of time frames. The calculation processing unit 12 applies modulation frequency analysis for each of the time frames to a measuring signal (digital value) of an electromagnetic noise in a time domain, and calculates the modulation frequency data of an electromagnetic noise from the suspected noise source devices. As a result, the calculation processing unit 12 acquires data of a frequency spectrum for each of the different time frames, and stores the data in the noise source database 13.

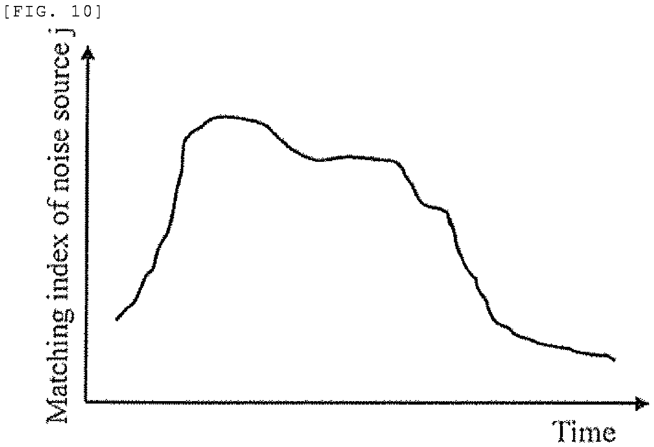

Thereafter, in step S22 (FIG. 8), the measuring unit 11 measures an electromagnetic noise received by the target device V for each of the plurality of time frames. The calculation processing unit 12 applies the modulation frequency analysis to a measurement result, acquires the modulation frequency data for each of the plurality of time frames, and stores the modulation frequency data in the noise source database 13. In step S23 (FIG. 8), the calculation processing unit 12 compares the modulation frequency data of the target device V (a result of the modulation frequency analysis) with the modulation frequency data of the suspected noise source devices S1 to Sn (a result of the modulation frequency analysis) for each time frame, and identifies or estimates a device that generates at least a part of the electromagnetic noise received by the target device V from among the suspected noise source devices S1 to Sn. Here, as illustrated in FIG. 10, for each of the suspected noise source devices S1 to Sn, the matching index for each time frame may be calculated and output.

In addition, in the step S22 (FIG. 8), it is not necessary for the measuring unit 11 to measure the electromagnetic noise received by the target device V for each of the plurality of time frames. In this case, the calculation processing unit 12 applies the modulation frequency analysis to the measurement result, acquires the modulation frequency data, and stores the modulation frequency data in the noise source database 13. In the step S23 (FIG. 8), the calculation processing unit 12 compares the modulation frequency data of the target device V (the result of the modulation frequency analysis) with the modulation frequency data of the suspected noise source devices S1 to Sn for each time frame (the result of the modulation frequency analysis), and identifies or estimates the device that generates at least a part of the electromagnetic noise received by the target device V from among the suspected noise source devices S1 to Sn.

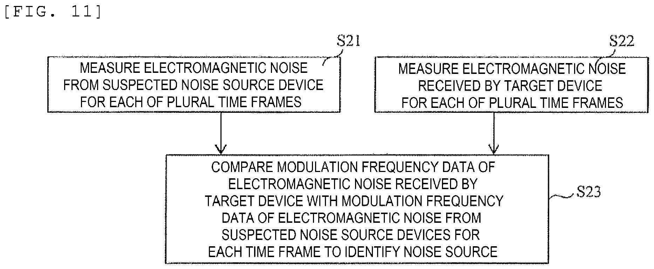

According to the fourth embodiment, since each of the suspected noise source devices S1 to Sn holds different modulation frequency data depending on a time zone, it is possible to identify a more precise noise source in consideration of a difference in time. As described above, the modulation frequency data of the suspected noise source devices S1 to Sn can be stored in a database before the modulation frequency data of the target device V is acquired, and as illustrated in FIG. 11, the measurement of the target device V (the step S22) and the measurement of the suspected noise source devices S1 to Sn (the step S21) can be performed in parallel.

### [Others]

The invention is not limited to the above embodiments and includes various modifications. For example, the above embodiment has been described in detail for easy understanding of the invention, and the invention is not necessarily limited to those including all of the configurations described above. In addition, a part of the configuration of the embodiment may be subjected to addition, deletion, and replacement of another configuration as long as the resulting subject-matter is covered by the appended claims. The first example and the second example may be combined to identify the noise source based on both the modulation frequency data and the data of the device characteristic information. In addition, it is also possible to use the identification of the noise source based on the result of the calculation processing in the calculation processing unit 12 and the visual identification of the noise source of the graph displayed on the display 15 in combination.

### Reference Sign List

11 measuring unit
12 calculation processing unit
13 noise source database
13A device characteristic information database
14 I/O interface
15 display
16 storage device

## Claims

1. An information processing system (1), comprising:
a measuring unit (11) configured to measure a first electromagnetic noise received by a target device (V);
a calculation unit (12) configured to calculate, from measurement data of the first electromagnetic noise, first modulation frequency data as a graph in which a frequency of the first electromagnetic noise, a modulation frequency of the first electromagnetic noise, and an intensity of the first electromagnetic noise are associated with each other, the frequency of the first electromagnetic noise being shown as a first axis, while the modulation frequency of the first electromagnetic noise being shown as a second axis;
an output unit (14, 15) configured to output the first modulation frequency data; and
a storage unit (16) configured to store second modulation frequency data in which a frequency of a second electromagnetic noise generated by one or more devices (S1-Sn) different from the target device (V) is shown as a first axis, while a modulation frequency of the second electromagnetic noise is shown as a second axis, and the frequency of the second electromagnetic noise, the modulation frequency of the second electromagnetic noise, and an intensity of the second electromagnetic noise are associated with each other,
wherein
the measuring unit (11) is configured to measure the second electromagnetic noise, and
the calculation unit (12) is configured to calculate the second modulation frequency data from measurement data of the second electromagnetic noise and store the second modulation frequency data in the storage unit (16),
the calculation unit (12) is configured to compare the second modulation frequency data with the first modulation frequency and identify a device (S1-Sn) that generates at least a part of the first electromagnetic noise from among the one or more devices (S1-Sn),
**characterised in that** the measurement data of the second electromagnetic noise is measurement data obtained by measuring the second electromagnetic noise for each of a plurality of time frames.

2. A noise source identification method by an information processing system (1), comprising the steps of:
measuring (S22) a first electromagnetic noise received by a target device (V);
calculating, from measurement data of the first electromagnetic noise, first modulation frequency data as a graph in which a frequency of the first electromagnetic noise, a modulation frequency of the first electromagnetic noise, and an intensity of the first electromagnetic noise are associated with each other, the frequency of the first electromagnetic noise being shown as a first axis, while the modulation frequency of the first electromagnetic noise being shown as a second axis; and
comparing (S23) information on one or more devices (S1-Sn) different from the target device (V) with the first modulation frequency data, and identifying a device (S1-Sn) that generates at least a part of the first electromagnetic noise from among the one or more devices (S1-Sn),
wherein the information on the one or more devices (S1-Sn) is information on a second electromagnetic noise generated by the one or more devices (S1-Sn), and the noise source identification method further comprises:
a step of measuring (S21) the second electromagnetic noise; and
a step of calculating second modulation frequency data from measurement data of the second electromagnetic noise and storing (S13; S13B) the second modulation frequency data in a storage unit (16),
wherein, in said comparing step (S23), the second modulation frequency data is compared with the first modulation frequency data,
**characterised in that** the measurement data of the second electromagnetic noise is measurement data obtained by measuring the second electromagnetic noise for each of a plurality of time frames.

## Patentansprüche

1. Informationsverarbeitungssystem (1), umfassend:
eine Messeinheit (11), die dazu konfiguriert ist, ein erstes elektromagnetisches Rauschen zu messen, das von einer Zielvorrichtung (V) empfangen wird;
eine Berechnungseinheit (12), die dazu konfiguriert ist, aus Messdaten des ersten elektromagnetischen Rauschens erste Modulationsfrequenzdaten als ein Diagramm zu berechnen, in dem eine Frequenz des ersten elektromagnetischen Rauschens, eine Modulationsfrequenz des ersten elektromagnetischen Rauschens und eine Intensität des ersten elektromagnetischen Rauschens einander zugeordnet sind, wobei die Frequenz des ersten elektromagnetischen Rauschens als eine erste Achse gezeigt wird, während die Modulationsfrequenz des ersten elektromagnetischen Rauschens als eine zweite Achse gezeigt wird;
eine Ausgabeeinheit (14, 15), die dazu konfiguriert ist, die ersten Modulationsfrequenzdaten auszugeben; und
eine Speichereinheit (16), die dazu konfiguriert ist, zweite Modulationsfrequenzdaten zu speichern, in denen eine Frequenz eines zweiten elektromagnetischen Rauschens, das von einer oder mehreren Vorrichtungen (S1-Sn), die sich von der Zielvorrichtung (V) unterscheiden, erzeugt wird, als eine erste Achse dargestellt wird, während eine Modulationsfrequenz des zweiten elektromagnetischen Rauschens als eine zweite Achse dargestellt wird, und die Frequenz des zweiten elektromagnetischen Rauschens, die Modulationsfrequenz des zweiten elektromagnetischen Rauschens und eine Intensität des zweiten elektromagnetischen Rauschens einander zugeordnet sind,
wobei
die Messeinheit (11) dazu konfiguriert ist, das zweite elektromagnetische Rauschen zu messen, und
die Berechnungseinheit (12) dazu konfiguriert ist, die zweiten Modulationsfrequenzdaten aus Messdaten des zweiten elektromagnetischen Rauschens zu berechnen und die zweiten Modulationsfrequenzdaten in der Speichereinheit (16) zu speichern,
die Berechnungseinheit (12) dazu konfiguriert ist, die zweiten Modulationsfrequenzdaten mit der ersten Modulationsfrequenz zu vergleichen und eine Vorrichtung (S1-Sn), die zumindest einen Teil des ersten elektromagnetischen Rauschens erzeugt, unter den ein oder mehreren Vorrichtungen (S1-Sn) zu identifizieren,
**dadurch gekennzeichnet, dass** es sich bei den Messdaten des zweiten elektromagnetischen Rauschens um Messdaten handelt, die durch Messung des zweiten elektromagnetischen Rauschens für jedes einer Vielzahl von Zeitfenstern erhalten werden.

2. Verfahren zum Identifizieren einer Rauschquelle durch ein Informationsverarbeitungssystem (1), das die folgenden Schritte umfasst:
Messen (S22) eines ersten elektromagnetischen Rauschens, das von einer Zielvorrichtung (V) empfangen wird;
Berechnen von ersten Modulationsfrequenzdaten aus Messdaten des ersten elektromagnetischen Rauschens als ein Diagramm, in dem eine Frequenz des ersten elektromagnetischen Rauschens, eine Modulationsfrequenz des ersten elektromagnetischen Rauschens und eine Intensität des ersten elektromagnetischen Rauschens einander zugeordnet sind, wobei die Frequenz des ersten elektromagnetischen Rauschens als eine erste Achse dargestellt wird, während die Modulationsfrequenz des ersten elektromagnetischen Rauschens als eine zweite Achse dargestellt wird; und
Vergleichen (S23) von Informationen über eine oder mehrere Vorrichtungen (S1-Sn), die sich von der Zielvorrichtung (V) unterscheiden, mit den ersten Modulationsfrequenzdaten, und Identifizieren einer Vorrichtung (S1-Sn), die zumindest einen Teil des ersten elektromagnetischen Rauschens erzeugt, unter der einen oder den mehreren Vorrichtungen (S1-Sn),
wobei die Informationen über die eine oder die mehreren Vorrichtungen (S1-Sn) Informationen über ein zweites elektromagnetisches Rauschen sind, das von der einen oder den mehreren Vorrichtungen (S1-Sn) erzeugt wird, und das Verfahren zum Identifizieren der Rauschquelle ferner umfasst:
einen Schritt (S21) zum Messen des zweiten elektromagnetischen Rauschens; und
einen Schritt zum Berechnen zweiter Modulationsfrequenzdaten aus Messdaten des zweiten elektromagnetischen Rauschens und Speichern (S13; S13B) der zweiten Modulationsfrequenzdaten in einer Speichereinheit (16),
wobei in dem Vergleichsschritt (S23) die zweiten Modulationsfrequenzdaten mit den ersten Modulationsfrequenzdaten verglichen werden,
**dadurch gekennzeichnet, dass** es sich bei den Messdaten des zweiten elektromagnetischen Rauschens um Messdaten handelt, die durch Messung des zweiten elektromagnetischen Rauschens für jedes einer Vielzahl von Zeitfenstern erhalten werden.

## Revendications

1. Système (1) de traitement d'informations, comprenant :
une unité (11) de mesure configurée pour mesurer un premier bruit électromagnétique reçu par un dispositif cible (V) ;
une unité (12) de calcul configurée pour calculer, à partir de données de mesure du premier bruit électromagnétique, des premières données de fréquence de modulation comme un graphique dans lesquelles une fréquence du premier bruit électromagnétique, une fréquence de modulation du premier bruit électromagnétique, et une intensité du premier bruit électromagnétique sont associées les unes avec les autres, la fréquence du premier bruit électromagnétique étant montrée comme un premier axe, tandis que la fréquence de modulation du premier bruit électromagnétique étant montrée comme un deuxième axe ;
une unité (14, 15) de sortie configurée pour délivrer en sortie les premières données de fréquence de modulation ; et
une unité (16) de stockage configurée pour stocker des deuxièmes données de fréquence de modulation dans lesquelles une fréquence d'un deuxième bruit électromagnétique généré par un ou plusieurs dispositifs (S1-Sn) différents du dispositif cible (V) est montrée comme un premier axe, tandis qu'une fréquence de modulation du deuxième bruit électromagnétique est montrée comme un deuxième axe, et la fréquence du deuxième bruit électromagnétique, la fréquence de modulation du deuxième bruit électromagnétique, et une intensité du deuxième bruit électromagnétique sont associées les unes avec les autres,
dans lequel
l'unité (11) de mesure est configurée pour mesurer le deuxième bruit électromagnétique, et
l'unité (12) de calcul est configurée pour calculer les deuxièmes données de fréquence de modulation à partir de données de mesure du deuxième bruit électromagnétique et stocker les deuxièmes données de fréquence de modulation dans l'unité (16) de stockage,
l'unité (12) de calcul est configurée pour comparer les deuxièmes données de fréquence de modulation avec la première fréquence de modulation et identifier un dispositif (S1-Sn) qui génère au moins une partie du premier bruit électromagnétique parmi le ou les dispositifs (S1-Sn),
**caractérisé en ce que** les données de mesure du deuxième bruit électromagnétique sont des données de mesure obtenues en mesurant le deuxième bruit électromagnétique pour chacun d'une pluralité d'intervalles de temps.

2. Procédé d'identification de source de bruit par un système (1) de traitement d'informations, comprenant les étapes de :
mesure (S22) d'un premier bruit électromagnétique reçu par un dispositif cible (V) ;
calcul, à partir de données de mesure du premier bruit électromagnétique, de premières données de fréquence de modulation comme un graphique dans lesquelles une fréquence du premier bruit électromagnétique, une fréquence de modulation du premier bruit électromagnétique, et une intensité du premier bruit électromagnétique sont associées les unes avec les autres, la fréquence du premier bruit électromagnétique étant montrée comme un premier axe, tandis que la fréquence de modulation du premier bruit électromagnétique étant montrée comme un deuxième axe ; et
comparaison (S23) d'informations sur un ou plusieurs dispositifs (S1-Sn) différents du dispositif cible (V) avec les premières données de fréquence de modulation, et identification d'un dispositif (S1-Sn) qui génère au moins une partie du premier bruit électromagnétique parmi le ou les dispositifs (S1-Sn),
dans lequel les informations sur le ou les dispositifs (S1-Sn) sont des informations sur un deuxième bruit électromagnétique généré par le ou les dispositifs (S1-Sn), et le procédé d'identification de source de bruit comprend en outre :
une étape de mesure (S21) du deuxième bruit électromagnétique ; et
une étape de calcul de deuxièmes données de fréquence de modulation à partir des données de mesure du deuxième bruit électromagnétique et de stockage (S13 ; S13B) des deuxièmes données de fréquence de modulation dans une unité (16) de stockage,
dans lequel, à ladite étape de comparaison (S23), les deuxièmes données de fréquence de modulation sont comparées avec les premières données de fréquence de modulation,
**caractérisé en ce que** les données de mesure du deuxième bruit électromagnétique sont des données de mesure obtenues en mesurant le deuxième bruit électromagnétique pour chacun d'une pluralité d'intervalles de temps.
